**Europäisches Patentamt**

**European Patent Office**

**Office européen des brevets**

(19)

(11) **EP 1 067 687 A2**

(12) **EUROPEAN PATENT APPLICATION**

(43) Date of publication:
**10.01.2001 Bulletin 2001/02**

(51) Int Cl.⁷: $H03H\ 11/34$

(21) Application number: **00440154.3**

(22) Date of filing: **25.05.2000**

| | |
|---|---|
| (84) Designated Contracting States:<br>**AT BE CH CY DE DK ES FI FR GB GR IE IT LI LU MC NL PT SE**<br>Designated Extension States:<br>**AL LT LV MK RO SI** | (72) Inventors:<br>• **Underwood, Grant James**<br>  **Gymea Bay, New South Wales 2227 (AU)**<br>• **Orr, Bruce Francis**<br>  **Balgowlah, New South Wales 2093 (AU)** |
| (30) Priority: **08.07.1999 AU 3907899** | (74) Representative: **Schäfer, Wolfgang**<br>**Dreiss Fuhlendorf, Steimle & Becker,** |
| (71) Applicant: **ALCATEL**<br>**75008 Paris (FR)** | **Gerokstrasse 6**<br>**70188 Stuttgart (DE)** |

(54) **Complex/resistive/ADSL/POTS line splitter**

(57)   In an ADSL/POTS filter, a subscriber line 1 having a complex impedance is interfaced to a line card at an exchange 4 via a passive filter 101. A passive impedance transformer 103 interfaces between the line card, which has a resistive impedance, and the filter 101. An active impedance converter 102 interfaces between the filter 101 and the line 1.

This arrangement optimizes performance for the VF telephony and ADSL frequencies.

FIGURE 1

EP 1 067 687 A2

## Description

The following statement is a full description of this invention, including the best method of performing it known to us:

## Technical Field

This invention relates to the field of cross-over filters for separating/combining signals of different frequencies applied to a line.

A particular application of the invention is as an ADSL/POTS filter.

## Background art

A cross-over filter must perform several functions and meet a variety of seemingly incompatible functional requirements. An article entitled "ADSL & VADSL Splitter Design and Telephony Performance" in IEEE journal on selected areas in communications, Vol. 13, No. 9, December 1995, at 1634. Authors: John Cook and Phil Sheppard discusses line filter performance with reference to both passive and active filters, and in particular discusses the use of a pair of generalized immittance converters (GIC) at page 1640 *et seq.*

Prior art line filter/splitters have presented the same type of impedance to the line as to the exchange e.g. resistive/resistive or complex/complex. Such a circuit is described in British Telecom's US patent 5623543.

However, in some countries the line card in the exchange presents a resistive impedance, while the line impedance is complex. Thus a filter/splitter which presents the same type of impedance to the line and the exchange will have an impedance mismatch at one interface.

This mismatch is usually acceptable for VF telephony. However, when significantly higher frequencies are used, such as in ADSL which may use frequencies »50KHz, the mismatch can significantly degrade the signals.

US patent 5623543 discloses a passive filter between a pair of back-to-back GIC's, and suggests that the GIC's need not necessarily be identical. However the patent does not suggest that the invention can be used to match resistive impedance (the exchange card) with a complex impedance (the line). Indeed, US patent 5623543 describes an arrangement for interfacing ADSL equipment and a telephone subset to a line at the subscriber's premises.

## Disclosure of the Invention

According to this invention, the line filter presents a resistive impedance to the exchange and a complex impedance to the line.

In one embodiment of the invention there is provided an ADSL/POTS filter 100 for matching a resistive exchange line matching impedance to a complex line impedance the filter including filter means 101 interfaced via a first port to the line via a first active impedance converter 102, the active impedance converter being adapted to present a complex impedance to the line,

- the filter means 101 being interfaced via a second port to the exchange via exchange impedance matching means 103, the exchange impedance matching means being adapted to match resistive impedances.

In a refinement of this embodiment the exchange impedance matching means includes a second active impedance converter adapted to present a resistive impedance to the exchange.

In a further embodiment the exchange impedance matching means may include a transformer.

## Brief Description of the Drawings

Figure 1     shows an arrangement for connecting the exchange and an ADSL service to the line.

Figure 2     illustrates a filter embodying the invention.

## Best mode of carrying out the invention

The invention will be described with reference to the drawings.

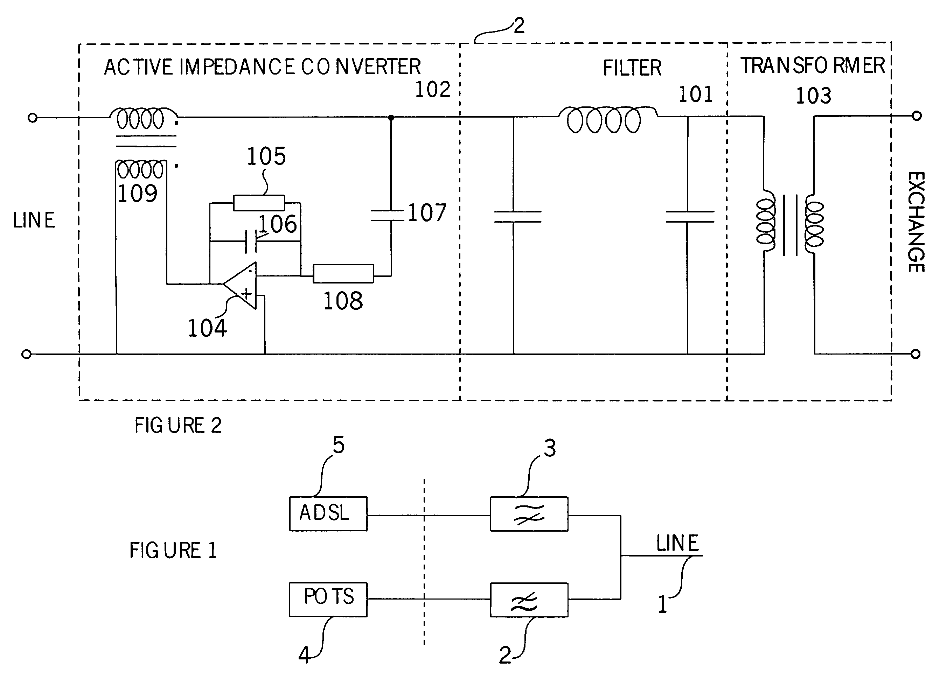

In Figure 1, a subscriber's line 1 is connected to the telephone service 4 of an exchange and to an ADSL service 5 via respective low pass filter 2 and high pass filter 3. Filters 2 and 3 should have non-overlapping pass bands and have good out-of-band rejection.

The invention is described with particular reference to filter 2 which connects the line 1 having a complex impedance to the line card of the exchange 2 having a resistive impedance.

Figure 2 illustrates an embodiment of the filter of Figure 1.

Essentially the Filter 2 has three distinguishable sections, an active impedance converter 102, a passive filter 101, and an impedance converter 103.

The active impedance converter 102 interfaces between the line 1 and the filter 101.

At telephony frequencies, the characteristic impedance of the line is:

$$Z_0 = \sqrt{(R + jWL)}\sqrt{(G + jWC)}$$

usually G is negligible, and L can be ignored at VF. Thus:

$$Z_{VF} \approx \sqrt{\frac{R}{j\omega C}} ,$$

which is a complex impedance.

On the other hand, the LC filter 101 normally has a purely resistive impedance. In order to match the filter to the line, it is thus necessary for the impedance converter 102 to present a complex impedance to the line.

The impedance converter 102 includes an amplifier 104 having a resistive (105) and a capacitive (106) feedback path. The input to the amplifier is via capacitor 107 and resistor 108. The output of amplifier 104 is applied to the line via transformer 109.

Analysis of the amplifier configuration shows that the transfer function is complex, and its characteristics can be controlled by selection of the associated components.

The impedance converter 102 changes the impedance by effectively multiplying it by a transfer function h(s). In this configuration the impedance converter 102 presents an impedance of h(s). $Z_F$ to the line, where $Z_F$ is the impedance presented to the exchange side of the converter 102.

Thus in the case where $Z_F$ is purely resistive, the converter 102 can present a complex impedance to the line where h(s) is a complex number. A complex transfer function is achieved in this embodiment by the use of the resistor 105 and capacitor 106 in parallel in the feedback path of amplifier 104.

The impedance converter 103 interfaces between the exchange 4 and the filter 101.

On the exchange side of the filter 101, the line card presents a resistive impedance. Thus, this can be matched to the filter by the use of a passive impedance converter such as the transformer shown at 103.

The filter 101 may be a higher order filter as described in US Patent 5623543.

It should be understood that the term "exchange" is used to identify the network side termination of the subscriber's line, and that the termination may be at a line card in a multiplexer between the subscriber and the rest of the network.

## Claims

1. An ADSL/POTS filter 100 for matching a resistive exchange line matching impedance to a complex line impedance the filter including filter means 101 interfaced via a first port to the line via a first active impedance converter 102, the active impedance converter being adapted to present a complex impedance to the line,

   - the filter means 101 being interfaced via a second port to the exchange via exchange impedance matching means 103, the exchange impedance matching means being adapted to match resistive impedances.

2. A filter as claimed in claim 1, wherein the exchange impedance matching means includes a second active impedance converter adapted to present a resistive impedance to the exchange.

3. A filter as claimed in claim 1, wherein the exchange impedance matching means includes a transformer.

4. An ADSL/POTS filter substantially as herein described with reference to the accompanying drawings.

5. An ADSL/POTS cross-over filter arrangement including a filter as claimed in any one of claims 1 to 4 for interfacing a line card to a subscriber line.

EXCHANGE

TRANSFORMER
103

FILTER
101

ACTIVE IMPEDANCE CONVERTER
102

105

106

104

107

108

109

2

LINE

FIGURE 2

LINE
1

3

2

5

ADSL

POTS
4

FIGURE 1